# EUROPEAN PATENT SPECIFICATION

(11) **EP 4 515 613 B1**
(45) Date of publication and mention of the grant of the patent: **11.11.2026**
(21) Application number: 23724679.8
(22) Date of filing: 28.04.2023
(51) Int. Cl.: H01M 8/04186, H01M 8/04276, H01M 8/18

(54) **FLOW BATTERY STATE OF HEALTH INDICATOR**
FLUSSBATTERIEGESUNDHEITSZUSTANDSINDIKATOR
INDICATEUR D'ÉTAT DE SANTÉ DE BATTERIE À CIRCULATION

(30) Priority: 28.04.2022 GB 202206248
(43) Date of publication of application: 05.03.2025
(73) Proprietor: Invinity Energy Systems (Ireland) Limited, Dublin 4 (IE)
(72) Inventor: WHITEHEAD, Adam Harding, 7000 Eisenstadt (AT); MCDERMOTT, Jack, Northolt UB5 6QN (GB); REID, Daniel, Bracknell, RG12 8BL (GB); LYONS, Phil, Falkirk FK2 7GY (GB)
(74) Representative: Ellis, Michael James
(86) International application number: PCT/EP2023/061367
(87) International publication number: WO 2023/209214

(56) References cited:
- JP-A- 2006 114 359
- KR-A- 20160 035 338
- US-A1- 2018 375 132

## Description

### FIELD OF THE INVENTION

This invention relates to the field of redox flow batteries. More particularly, it relates to the state of health or state of charge of the electrolytes of a flow battery, to a device or reference cell for detecting the state of health or state of charge of an electrolyte, to a method of manufacture of such a device, to a method of detecting, monitoring or correcting the state of health or state of charge of an electrolyte in a flow battery and to a redox flow battery having a state of health indicator therein.

### BACKGROUND OF THE INVENTION

Redox flow batteries, such as vanadium redox flow batteries, can become imbalanced with respect to the state of charge of their positive and negative electrolytes over time or through use.

A consequence of the vanadium redox flow batteries becoming imbalanced in terms of the state of charge is that it reduces the energy storage capacity and performance of the flow battery.

In order to determine the imbalance of the state of charge of the flow battery, it is necessary to have a measure or indication of the state of charge of each of the positive and negative electrolytes. Absent reliable information about the balance of charge between the two electrolytes, the flow battery may operate on incorrect information and this can lead to hazards resulting from attempts to over-charge or over-discharge an electrolyte, or at least can limit the depth of discharge available and battery efficiency. A lack of reliable information on balance of charge between the two electrolytes also has the effect that remedial or corrective action (whether manual or automatic) is not timely facilitated.

Several methods for measuring the state of charge of electrolytes in flow batteries have been proposed.

In WO-A-90/03666, a method is described in which the state of charge of both electrolytes may be performed indirectly by making use of optical absorption, density and viscosity measurements. However, optical measurements are subject to instrument drift (due to changes in the light source and detector with time and temperature) while in-line density and viscosity measurements require expensive equipment (especially in the relatively harsh chemical conditions and to the high level of resolution required for a VRFB).

In JP 09-101286, an in-line potentiometric titration technique is proposed. However, this method is limited by the extreme demands placed on controlling the titration volumes of the electrolytes and is therefore impractical in commercial systems.

The measurement of electrolyte potential at an inert redox electrode has also previously been proposed.

In WO-A-90/03666, a conventional reference electrode is suggested. However, reference electrodes are subject to contamination and hence voltage drift after extended periods of immersion in a test electrolyte. Therefore, these are not practical for commercial systems with months or years between services.

In WO-A-2014/184617, a dynamic hydrogen electrode is proposed. The dynamic hydrogen electrode uses platinum-group metals to catalyse hydrogen evolution. Unfortunately, these tend to dissolve or be poisoned in electrolyte and hence give unstable results after extended periods of time. Additionally, dissolved catalysts deposit on the negative electrodes of the flow battery and lead to acceleration of imbalance reactions (hydrogen evolution).

In US-A-2018/0375132, a reference cell with a reference electrolyte of similar composition and known state of charge in one half-cell is proposed with a test electrolyte flowed through the other half-cell. However, a membrane-separated cell is subject to mass transfer through the membrane, leading to relatively rapid change in the composition of the reference electrolyte

The present inventors have devised a device and arrangement whereby state of charge of electrolytes in a redox flow battery can be detected or verified that is straightforward to implement, cost effective and robust.

### PROBLEM TO BE SOLVED BY THE INVENTION

There is a need for a robust and inexpensive method and device to independently measure or detect the state of charge of each electrolyte in a redox flow battery.

It is an object of this invention to provide a method and device or system which can measure or detect the state of charge of one or both electrolytes and/or determine the state of health of a flow battery.

It is a further object of the invention to provide a method and device or system to determine when an operation should be undertaken to address an imbalance in the state of charge between electrolyte in a flow battery.

### SUMMARY OF THE INVENTION

In accordance with a first aspect of the invention, there is provided a state of charge or state of health indicator arrangement for a redox flow battery system comprising a redox flow battery cell stack, a positive electrolyte tank and pipework to circulate positive electrolyte through the cell stack and a negative electrolyte tank and pipework to circulate negative electrolyte through the flow battery cell stack, the indicator arrangement comprising:
a reference cell arrangement comprising a means for measuring potential difference between a positive electrolyte of or from the positive electrolyte tank of a flow battery and a negative electrolyte of or from the negative electrolyte tank of a flow battery; and
at least one auxiliary reference electrolyte arrangement comprising
   a discrete auxiliary electrolyte reservoir for housing a redox electrode in association with a reference electrolyte of known composition comparable to the desired or initial composition of the flow battery electrolyte for which it provides a reference and having known state of charge;
   a means of measuring the potential difference between the or each auxiliary reference electrolyte and the respective electrolyte of the reference cell arrangement; and
   an ionic pathway conduit linking the or each auxiliary reference electrolyte reservoir with the respective electrolyte of the reference cell arrangement, which conduit is configured for low fluid diffusion capability or rate, wherein the conduit comprises a wicking means for absorbing electrolyte and maintaining ionic connection between the auxiliary reference electrolyte reservoir and the respective electrolyte of the reference cell arrangement.

There is also disclosed a state of charge or state of health indicator arrangement (or apparatus or system) for a redox flow battery system comprising a redox flow battery cell stack, a positive electrolyte tank and pipework to circulate positive electrolyte through the cell stack and a negative electrolyte tank and pipework to circulate negative electrolyte through the flow battery cell stack, the indicator arrangement comprising:
a reference cell comprising a positive half-cell having a positive electrolyte reservoir configured for fluid circulatory communication with the positive electrolyte tank of a flow battery, a negative half-cell having a negative electrolyte reservoir configured for fluid circulatory communication with the negative electrolyte tank and a means for measuring potential difference across the reference cell; and
at least one auxiliary reference electrolyte arrangement (or apparatus or system or sub-system) comprising
   a discrete auxiliary electrolyte reservoir for housing a redox electrode in association with a reference electrolyte of known composition comparable to the desired or initial composition of the flow battery electrolyte for which it provides a reference and having known state of charge;
   a means of measuring the potential difference between the or each auxiliary reference electrolyte and the respective half-cell of the reference cell; and
   an ionic pathway conduit linking the or each auxiliary reference electrolyte reservoir with the electrolyte in the respective half-cell of the reference cell, which conduit is configured for low fluid diffusion capability or rate, preferably wherein the conduit comprises a wicking means, preferably for absorbing electrolyte and maintaining ionic connection between the auxiliary reference electrolyte reservoir and the electrolyte in the respective half-cell of the reference cell.

There is also disclosed a state of charge or state of health indicator arrangement for a redox flow battery system comprising a redox flow battery cell stack, a positive electrolyte tank and pipework to circulate positive electrolyte through the cell stack and a negative electrolyte tank and pipework to circulate negative electrolyte through the flow battery cell stack, the indicator arrangement comprising:
at least one auxiliary reference electrolyte arrangement comprising
a discrete auxiliary electrolyte reservoir for housing a redox electrode in association with a reference electrolyte of known composition comparable to the desired or initial composition of the flow battery electrolyte for which it provides a reference and having known state of charge;
a means of measuring the potential difference between the or each auxiliary reference electrolyte and the respective electrolyte of the flow battery (or reference cell arrangement); and
an ionic pathway conduit linking the or each auxiliary reference electrolyte reservoir with the respective electrolyte of the flow battery (or reference cell arrangement thereof), which conduit is configured for low fluid diffusion capability or rate, preferably wherein the conduit comprises a wicking means, which is preferably for absorbing electrolyte and maintaining ionic connection between the auxiliary reference electrolyte reservoir and the respective electrolyte of the flow battery (or reference cell arrangement thereof);
and a means for determining the state of charge, or a proxy for the state of charge, of the other electrolyte of the flow battery (typically the negative electrolyte) such as by providing a reference cell comprising a positive half-cell having a positive electrolyte reservoir configured for fluid circulatory communication with the positive electrolyte tank of a flow battery, a negative half-cell having a negative electrolyte reservoir configured for fluid circulatory communication with the negative electrolyte tank and a means for measuring potential difference across the reference cell.

In a second aspect of the invention, there is provided a state of health indicator system for a redox flow battery system, the indicator system comprising a state of charge indicator arrangement as defined in the first aspect above and configured to determine a state of health of the redox flow battery system therefrom, preferably by obtaining measurement of state of charge of at least one electrolyte of the flow battery and of the other electrolyte or a proxy thereof (optionally continuously, periodically or intermittently), preferably determining the relative oxidation states of the respective electrolytes and preferably causing an alarm, indication or remedial action in response to the determined relative oxidation states falling outside a predetermined limit.

In a third aspect of the invention, there is provided an auxiliary reference electrolyte arrangement for a state of charge or state of health indicator as defined in the first aspect above, the auxiliary reference electrolyte arrangement comprising
a discrete auxiliary electrolyte reservoir for housing a redox electrode in association with a reference electrolyte of known composition comparable to the desired or initial composition of the flow battery electrolyte for which it provides a reference and having known state of charge;
a means of measuring the potential difference between the or each auxiliary reference electrolyte and an associated electrolyte of a reference cell arrangement or an associated half-cell of a reference cell; and
an ionic pathway conduit for linking the or each auxiliary reference electrolyte reservoir with an electrolyte in a respective electrolyte of a reference cell arrangement or in a respective half-cell of a reference cell, which conduit is configured for low fluid diffusion capability or rate, wherein the conduit comprises a wicking means for absorbing electrolyte and maintaining ionic connection between the auxiliary reference electrolyte reservoir and the respective electrolyte of the reference cell arrangement or in a respective half-cell of a reference cell.

In a fourth aspect of the invention, there is provided a redox flow battery comprising a redox flow battery cell stack, a positive electrolyte tank and pipework to circulate positive electrolyte through the cell stack and a negative electrolyte tank and pipework to circulate negative electrolyte through the flow battery cell stack and a state of charge or state of health indicator as defined in the first aspect above.

In a fifth aspect of the invention, there is provided a method of monitoring the state of charge or state of health in a redox flow battery, the method comprising providing a state of charge or state of health indicator as defined in the first aspect above and causing the state of charge or state of health indicator to make periodic measurements of charge across the reference cell and between the auxiliary reference electrolyte and a respective half-cell of the reference cell and determining therefrom a state of charge of the system and optionally, in dependence on the state of charge differing across the reference cell of the flow battery by a pre-determined threshold, raising an alert of imbalance of electrolyte charge of the flow battery.

In a sixth aspect of the invention, there is provided a method for maintaining a balanced state of charge in a redox flow battery, the method comprising:
monitoring the state of charge in the flow battery by providing a state of charge or state of health indicator as defined above and causing the state of charge or state of health indicator to make periodic or action or event-dependent measurements of charge across the reference cell and between the auxiliary reference electrolyte and a respective half-cell of the reference cell and determining therefrom a state of charge of the system; and
in dependence of the state of charge variance between the positive electrolyte and the negative electrolyte exceeding one or more pre-determined thresholds or meeting one or more pre-determined criteria, causing one or more maintenance actions to be applied to the flow battery.

### ADVANTAGES OF THE INVENTION

The state of charge or state of health indicator of the present invention provides the advantage of robustness of a standard reference cell but with consistency in measurement over the flow battery lifetime by taking account of voltage drift in the reference cell resulting from contamination of the battery electrolyte, thereby providing more accurate measurements of state of health of the battery and fuller, safe use of the battery's capacity over its lifetime.

### BRIEF DESCRIPTION OF THE DRAWINGS

Figure 1 shows in perspective view a perspective view of a state of charge indicator arrangement according to one embodiment of the present invention;
Figures 2a to 2c are perspective views of ionic pathway conduit tubes for use in the state of charge indicator arrangement according to embodiments of the present invention; and
Figure 3 is a representation of a state of charge or state of health indicator according to an embodiment of the invention;
Figure 4 is a simplified piping and instrumentation diagram of a flow battery of an embodiment of one aspect of the invention incorporating a state of charge or state of health indicator of an embodiment of another aspect of the invention;
Figures 5a and 5b are graphs of voltage against absolute current for a flow battery reference cell (Figure 5a) and between a positive electrode of a flow battery reference cell and an auxiliary electrolyte (Figure 5b) in a flow battery incorporating a state of charge indicator according to one embodiment of the invention; and
Figure 6 shows an image of an experimental set-up for determining diffusion rate through an ionic path conduit in an auxiliary reference electrolyte arrangement for use in an embodiment of the invention.

### DETAILED DESCRIPTION OF THE INVENTION

A state of charge indicator or state of health indicator for a redox flow battery system according to the invention is for a redox flow battery having a redox flow battery cell stack, a positive electrolyte tank, a negative electrolyte tank and pipework to circulate electrolyte from the respective tanks through respective portions of the cell stack.

By cell stack as used herein, it is meant a flow battery cell in addition to any membrane, electrodes or current collector and cell frame and it may comprise one or a plurality of cells (typically arranged in parallel and served by a single combined supply of electrolyte, or multiple parallel supplies, from each electrolyte tank).

A flow battery cell typically comprises two half-cells for containing electrolyte, which is supplied from a respective electrolyte tank, and separated by an ion-selective membrane. Each half-cell is provided with an electrode or current collector which is connected to an electrical circuit which provides a power source or load, for use in charging or discharging the battery.

The electrolyte is typically circulated through the cell or cell stack from each electrolyte tank using a pump.

The state of charge or state of health indicator arrangement comprises at least one auxiliary reference electrolyte (interchangeably referred to herein as an auxiliary electrolyte) arrangement, which is configured to determine the state of charge of one electrolyte of the flow battery (normally the positive electrolyte). Optionally, a second auxiliary electrolyte arrangement is provided in order to determine the state of charge of a second (normally the negative) electrolyte of the flow battery.

The state of charge or state of health indicator comprises one of a reference cell, a reference cell arrangement or a means for determining the state of charge of a second/other electrolyte of the flow battery (the first electrolyte being the one the auxiliary electrolyte arrangement determines), which second/other electrolyte is typically the negative electrolyte, or it comprises a proxy means for determining information as a proxy for the state of charge of the second (typically negative) electrolyte.

A means for determining the state of charge of a second/other electrolyte of the flow battery may be any suitable means, for example it could be a second auxiliary electrolyte arrangement provided in order to determine the state of charge of the second (normally the negative) electrolyte of the flow battery. A proxy means for determining information as a proxy for the state of charge of the second (typically negative) electrolyte may be any suitable means which is approximate to or can be estimated from a measure of the proxy means. In a particularly preferred embodiment, the proxy means is a reference cell arrangement or reference cell for the flow battery.

A reference cell arrangement comprises a means for measuring potential difference between a positive electrolyte of or from the positive electrolyte tank of a flow battery and a negative electrolyte of or from the negative electrolyte tank of a flow battery. Preferably, the state of charge or state of health indicator arrangement comprises (and the reference cell arrangement is) at least one reference cell for the flow battery.

The means for measuring potential difference between a positive electrolyte of or from the positive electrolyte tank of a flow battery and a negative electrolyte of or from the negative electrolyte tank of a flow battery in the reference cell arrangement may comprise an electrode disposed in relation to each electrolyte, such as in relation to each electrolyte tank and a voltmeter or similar instrumentation connected to both electrodes (to measure the potential difference).

The at least one reference cell (included in certain aspects and in preferred embodiments of the invention) comprises a positive half-cell having a positive electrolyte reservoir for fluid circulatory communication with the positive electrolyte tank of a flow battery and a negative half-cell having a negative electrolyte reservoir configured for fluid circulatory communication with the negative electrolyte tank. The at least one reference cell comprises a means for measuring potential difference across the reference cell. This may comprise, for example, an electrode disposed in relation to each half-cell and a voltmeter or similar instrumentation connected to each electrode. This is preferably configured to determine the open circuit voltage across the reference cell, that is between the positive and negative electrolytes in the flow battery.

The positive and negative half-cells of the reference cell may be in fluid communication with the respective electrolyte tank of a flow battery by any suitable means, such as pipes linking the positive and negative half-cells of the reference cell with the respective electrolyte tank, more preferably with the pipework to circulate electrolyte from the tanks to and/or from the flow battery cell stack. Optionally, the half-cells of the reference cell are connected to the electrolyte tanks via pipes to and from the return arm of the pipework for circulating electrolyte from the tanks through the flow battery cell stack, but preferably from the pipes delivering electrolyte from the tanks to the cell stack (e.g. just before the electrolyte enters the cell stacks).

Preferably, electrolyte flows to the reference cell in parallel to its flow to the cell stack(s). The positive and negative electrolyte is taken (using a branch in the piping) at a point close to the inlets of the cell stack and may be returned at any point downstream of the stacks (between the stack outlets and tanks) or directly into the tanks.

There is typically in a reference cell one inlet and one outlet for the positive electrolyte (through one half-cell of the reference cell) and one inlet and one outlet for the negative electrolyte (through the opposing half-cell of the reference cell). Preferably the electrolytes are electronically separated but ionically connected through an ion-exchange (or microporous) membrane in the reference cell.

The altitude of the reference cell, with respect to the tanks and stacks is not critical. In practice, the reference cell is preferably positioned at about the same level as the cell stacks (to prevent syphoning electrolyte out of the tanks, if they are positioned too low and in the event of a leakage).

Preferably, the reference cell is provided with a temperature sensor or thermometer, to allow any measurements of potential difference relating to the reference cell to be adjusted for temperature. Optionally, the temperature sensor may be configured to measure or determine the temperature of the reference cell in electrolyte within one or both half-cells of the reference cell and/or on other components of the reference cell (e.g. casing).

The auxiliary reference electrolyte arrangement, which is feature of the state or charge or state of health indicator and is a further aspect of the invention, comprises a discrete auxiliary electrolyte reservoir, a means of measuring potential difference between the or each auxiliary reference electrolyte and a respective half-cell of the reference cell (or a respective electrolyte of a reference cell arrangement or flow battery) and an ionic pathway conduit linking the or each auxiliary reference electrolyte reservoir with the respective half-cell of the reference cell (or the respective electrolyte of a reference cell arrangement or flow battery). Preferably, the ionic pathway conduit comprises a wicking means, which is preferably for absorbing electrolyte and maintaining ionic connection between the auxiliary reference electrolyte reservoir and the respective half-cell of the reference cell (or the respective electrolyte of the reference cell arrangement or flow battery).

In some applications a temperature gradient may occur which causes degassing of gases dissolved in electrolyte located in the ionic pathway conduit. The degassing may result in the formation of bubbles in the ionic pathway conduit, which bubbles can disrupt the ionic connection through the ionic pathway conduit. An advantage of the wicking means is that in the event of bubble formation electrolyte absorbed by the wicking means maintains an ionic connection through the ionic pathway conduit.

Optionally, the wicking means may extend through only a portion of the ionic pathway conduit, for example at a high point or at or through two or more high points of the ionic pathway conduit, which are at risk of bubble formation or residence.

Preferably, the wicking means extends continuously along a full length of the ionic pathway conduit.

Preferably, the wicking means extends from the ionic pathway conduit into the auxiliary reference electrolyte reservoir and/or the respective half-cell of the reference cell (or the respective electrolyte of the reference cell arrangement or flow battery). Preferably, the wicking means extends from the ionic pathway conduit by up to 10 mm, more preferably up to 8 mm, still more preferably up to 6 mm, e.g. by 5 mm. Preferably, the wicking means extends from the ionic pathway conduit by at least 0.5 mm, more preferably at least 1 mm, still more preferably at least 2 mm, for example at least 3 mm.

Preferably, the wicking means is hydrophilic and/or electrically non-conducting (typically σ < 10⁻³ S/cm). Preferably, the wicking means comprises (or consists of) silica, ceramic and/or hydrophilic polymer, for example silica, ceramic and/or hydrophilic polymer fibers.

Preferably, the wicking means is a wick or cord, preferably consisting of bundled (e.g. woven, twisted or braided) fibers. Preferably, the wicking means is a wick or cord having a diameter of from 0.4 mm to 8 mm, preferably from 1 mm to 6 mm, more preferably from 2 mm to 4 mm, e.g. around 3 mm.

In one embodiment, the ionic pathway conduit is defined by the wicking means which optionally extends through a flexible sleave or tube.

The discrete auxiliary electrolyte reservoir is for housing a redox electrode and a reference electrolyte. The reference electrolyte is selected of known composition, which is preferably the same as the desired composition of the respective electrolyte of the flow battery and at a pre-defined and known state of charge. The desired composition of the respective electrolyte of the flow battery is typically the initial composition (before any degradation or contamination has taken place). The discrete auxiliary electrolyte reservoir may be of any suitable size. For example, the discrete auxiliary electrolyte reservoir may have an electrolyte volume of preferably at least 10 ml and preferably no more than 10L. More preferably, the electrolyte volume is in the range of from 30 ml to 1000 ml, more preferably from 50 ml to 750 ml and still more preferably at least 100 ml. In one embodiment, the electrolyte volume is at least 400 ml in volume, such as from 400 ml to 600 ml. In another embodiment, especially where the ionic pathway conduit is relatively narrow, long or curved/looped (as discussed below), the discrete auxiliary electrolyte reservoir has a volume of up to 500 ml, e.g. from 100 ml to 350 ml and more preferably up to 250 ml and still more preferably up to 200 ml.

The discrete auxiliary electrolyte reservoir is preferably a housing containing a space or volume for receiving an amount of electrolyte as described above and for receiving or housing a redox electrode for use in measuring or detecting potential difference between the auxiliar electrolyte in the reservoir and an electrolyte elsewhere.

The redox electrode may take virtually any form. It may be a simple flat plate, rod or a space-filling porous 3D shape (felt, foam, etc). It must be positioned so that it is (at least partly) immersed in electrolyte in the auxiliary reservoir. The redox electrode should be chemically stable against the electrolyte in this reservoir. For that reason, carbon or carbon-composite materials (e.g. carbon and polypropylene) are preferred.

Preferably, the auxiliary reference electrolyte arrangement further comprises a temperature sensor, which is preferably associated with the discrete auxiliary electrolyte reservoir or housing or fixings in thermal communication therewith, in order to correct any potential difference measurements for temperature. The temperature sensor may take any suitable form. Since the temperature sensor is intended to measure the temperature of the electrolyte in the discrete auxiliary electrolyte reservoir, it must be in good thermal contact with the electrolyte. For example, it may be immersed in the electrolyte (possibly in a thermal well, or with a suitable protective coating), or in intimate contact with the electrode (carbon generally has a high thermal conductivity and so can be used to transfer heat to the thermal sensor). The second option would typically require some insulation around the thermal sensor on the air side, to gain an accurate measurement.

The means of measuring potential difference between the or each auxiliary reference electrolyte and a respective half-cell of the reference cell (or a respective electrolyte of a reference cell arrangement or flow battery) may be any suitable device or instrument, such as a voltmeter connected to the redox electrode in the discrete auxiliary electrolyte reservoir and a suitable electrode in the or each respective half-cell of the reference cell (or in or association with the or each electrolyte of a reference cell arrangement or flow battery, such as the electrolyte tanks).

The ionic pathway conduit linking the or each auxiliary reference electrolyte reservoir with the respective half-cell of the reference cell is configured for low fluid diffusion capability or rate. The ionic pathway conduit may be provided by any suitable means, but typically comprises a tubular member providing a fluid connection between the auxiliary reference electrolyte reservoir and the half-cell of the reference cell (or electrolyte therein). Preferably, where the ionic pathway conduit comprises a tubular member, the wicking means (which may for example be a wick or cord as defined above) is disposed inside the tubular member. Preferably, the ionic pathway conduit has a resistivity along its length (e.g. between the auxiliary reference electrolyte reservoir and the reference cell half-cell) of less than or equal to 1 MOhm. Preferably, the ionic pathway conduit is absent any membrane or barrier that may prevent (or inhibit) ionic and fluid communication between the auxiliary reference electrolyte and the respective half-cell of the reference cell, which are rather preferably openly fluidly connected by the ionic pathway conduit.

The ionic pathway conduit may be any suitable length, preferably of a suitable length (dependent upon the geometry, such as bore diameter, curvature and loops) to inhibit rapid fluid mixing of the auxiliary electrolyte and the flow battery electrolyte which are in fluid connection by way of the ionic pathway conduit. Preferably, the ionic pathway conduit has a length of at least 5 cm and more preferably of up to 10 m. More preferably, the ionic pathway conduit has a length of no more than 5 m, preferably no more than about 2 to 2.5 m. Preferably, the ionic pathway conduit has a length in the range of 10 cm to 1.5 m, more preferably from 15 cm to 1.2 m, e.g. from 20 cm to 1 m or optionally up to 75 cm and preferably from about 30 to about 50 cm. In one embodiment, e.g. if a larger bore diameter tube is utilized as the ionic pathway conduit, the length may be greater, e.g. from 50 cm to 5 m, such as from 1.5 m to 2.5 m.

The ionic pathway conduit may have any suitable bore diameter, which in order to inhibit mixing of the auxiliary electrolyte and the flow battery electrolyte through the conduit may be selected in dependence on the length and other geometrical features of the conduit. Preferably, the ionic pathway conduit has a bore diameter of at least 0.5 mm. The bore diameter may be up to 10 mm, preferably no more than 7.5 mm. Preferably, the ionic pathway conduit is a small bore conduit and preferably is of a sufficiently small bore so as to inhibit laminar flow of electrolyte through the conduit. More preferably, the ionic pathway conduit has an internal bore diameter in the range from 1 to 5 mm, preferably from 2.5 to 4 mm, such as from 3 to 3.5 mm.

Preferably, where the ionic pathway conduit comprises a tube member, the wicking means (e.g. a wick or a cord as defined above) has a diameter smaller than an inner/bore diameter of the tube member. Thus, preferably, the wicking means fits loosely within the bore of a tube member of the ionic pathway conduit. An advantage of this feature is that the wicking means can be readily inserted through a tube member of the ionic pathway conduit during assembly. A further advantage of this feature is that electrolyte may be disposed along the length of the ionic pathway conduit in a space between the wicking means and an inner/bore surface of a tube member of the conduit.

The internal diameter of the ionic pathway conduit should be low enough to prevent laminar flow (which could facilitate mixing between the auxiliary electrolyte and the flow battery electrolyte but large enough that it is not at high risk of blockage by small particulates that may be present in the flow battery electrolyte, for example).

In one option, for example where the ionic pathway conduit does not comprise a wicking means, it is advantageous to have a slightly larger conduit bore diameter. This is because bubbles resulting from the degassing of electrolyte in the ionic pathway conduit are then less likely to occlude the full inner/bore diameter of the conduit. Therefore, in this option, it is preferred that the ionic pathway conduit has a bore diameter of at least 3 mm, more preferably at least 4 mm, still more preferably at least 5 mm. The bore diameter may be up to 10 mm, preferably no more than 8 mm. Preferably, the ionic pathway conduit has an internal bore diameter in the range from 3.5 mm to 7.5 mm, more preferably from 4 mm to 7 mm, such as from 4.5 mm to 6 mm, e.g. an internal bore diameter of 5 mm.

In one embodiment, the ionic pathway conduit has a length of from 20 cm to 2 m and an internal diameter of from 2.5 to 4 mm.

Preferably, the ionic pathway conduit has one or more curved portions or bends along its length. Preferably the ionic pathway conduit has one or more vertical components associated with the one or more curved portions or bends. The curved portions or bends may cause a change in tangential orientation along the length of the ionic pathway of at least 30°, preferably at least 60°, more preferably at least 90°, more preferably at least 120°, such as at least 180 and more preferably at least 270° and still more preferably more greater than 360°.

Preferably the at least one curved portion or bends in the ionic pathway conduit defines at least one U-bend or loop. The orientation of the U-bend or loop preferably has a vertical component. Preferably, the ionic pathway conduit defines along its length at least one loop, more preferably two or more loops, such as three loops. It is believed that having at least two loops in the ionic pathway conduit between auxiliary electrolyte reservoir and the reference cell is particularly advantageous in slowing down the mixing of the flow battery electrolyte with the auxiliary electrolyte (e.g. by comparison with one loop or no loops). As a consequence, including one loop or preferably two loops (preferably with a vertical component) reduces the speed of mixing of the auxiliary electrolyte with the electrolyte of the flow battery (or reference cell) and therefore means that a smaller volume of auxiliary electrolyte could be used for the same effective service life of state of charge indicator, or the service life of the state of charge indicator could be increased for the same volume of auxiliary electrolyte.

The state of charge or state of health indicator according to the present invention may be configured such that the auxiliary electrolyte corresponds to a positive electrolyte of the flow battery (e.g. has a composition corresponding to a desired or initial composition of the positive electrolyte of the flow battery) or corresponds to a negative electrolyte of the flow battery (e.g. has a composition corresponding to a desired or initial composition of the positive electrolyte of the flow battery).

Optionally, there are two auxiliary reference electrolyte arrangements. In one such embodiment, one auxiliary reference electrolyte arrangements corresponds with a positive electrolyte of the flow battery (and preferably a first half-cell of the reference cell) while the other auxiliary reference electrolyte arrangement corresponds with the negative electrolyte of the flow battery (and preferably a second half-cell of the reference cell). In another such embodiment, both auxiliary reference electrolyte arrangements are selected to comprise an electrolyte corresponding to the positive electrolyte of the flow battery, where one is linked via an ionic pathway conduit to the positive electrolyte (e.g. positive half-cell of the reference cell) and the other is linked via a pathway conduit to the negative electrolyte (e.g. negative half-cell of the reference cell) and the state of charge of each electrolyte of the flow battery is determined from measurements of potential difference between the respective electrolyte of the flow battery (or half-cell of the reference cell) and the respective ionic pathway conduit-linked auxiliary reference arrangements.

Preferably, at least one auxiliary electrolyte corresponds to the positive electrolyte and the auxiliary reference electrolyte arrangement (or pseudo reference cell) is configured such that the means of measuring the potential difference is between the auxiliary reference electrolyte and the positive half-cell of the reference cell and the ionic pathway conduit links the auxiliary reference electrolyte reservoir with the positive half-cell of the reference cell. Optionally, the state of charge or state of health indicator also comprises a second auxiliary reference electrolyte arrangement in which a second auxiliary electrolyte corresponds to the negative electrolyte of the flow battery (or it may correspond also to the positive electrolyte) and the second auxiliary reference electrolyte arrangement (or pseudo reference cell) is configured such that its means of measuring the potential difference is between the second auxiliary reference electrolyte and the negative half-cell of the reference cell and its ionic pathway conduit links the auxiliary reference electrolyte reservoir with the negative half-cell of the reference cell.

Preferably, the state of charge or state of health indicator comprises a temperature sensor for measuring the temperature of the respective or each flow battery electrolyte.

The state of charge or state of health indicator may further comprise a processor for controlling the measurement taking and recording of potential differences and temperatures in relation to the or each auxiliary reference electrode arrangement and the respective or each half-cell of the reference cell and optionally is configured to communicate said measurements to a controller or data logger for the flow battery. Preferably the processor is or is a part of a processor for controlling or managing the operation of the flow battery to which the state of charge or state of health indicator is connected.

Preferably, the state of charge indicator is configured to measure state of charge at pre-determined periods or in dependence on pre-determined system actions. For example, the state of charge indicator arrangement may be configured to determine a state of charge every 24 hours or every 7 days, preferably from every 24 hours to every 3 months, more preferably every two days to every 2 months, e.g. from once a week to once a month. Additionally or alternatively, the state of charge indicator arrangement may be configured to determine a state of charge after every charge-discharge cycle or after every thousand charge-discharge cycles, such as from 10 to 500 charge-discharge cycles, e.g. from 50 to 250 charge-discharge cycles.

The state of charge indicator may be configured to take measurements (e.g. potential difference/temperature) from which a determination of state of charge may be made at any time, whether the flow battery is cycling or static, during a charge cycle or a discharge cycle, but preferably when the flow battery is cycling. Further, such measurements may be taken at any assumed state of charge, but preferably is in a medial assumed state of charge, e.g. from 20 to 80% state of charge, e.g. from 40 to 60% state of charge and preferably around 50% assumed charge.

The state of charge indicator as described herein is typically and preferably incorporated into or fitted to a redox flow battery.

As such, in a further aspect of the invention, there is provided a redox flow battery comprising a redox flow battery cell stack, a positive electrolyte tank and pipework to circulate positive electrolyte through the cell stack and a negative electrolyte tank and pipework to circulate negative electrolyte through the flow battery cell stack and a state of charge or state of health indicator as described above.

The redox flow battery may be of any suitable type, especially where imbalance of state of charge can arise (e.g. through hydrogen evolution), but, in any case, is preferably a vanadium redox flow battery.

In another aspect of the invention mentioned above, is a method of monitoring the state of charge or state of health in a redox flow battery, the method comprising providing a state of charge or state of health indicator as described above and causing the state of charge indicator to make periodic or occasional measurements of charge across the reference cell and between the auxiliary reference electrolyte and a respective half-cell of the reference cell and determining therefrom a state of charge of the system and optionally, in dependence on the state of charge differing across the reference cell of the flow battery by a pre-determined threshold, raising an alert of imbalance of electrolyte charge of the flow battery.

Such an alert may be, for example, an alarm, warning light, a notification [e.g. emailed or sms to an engineer or notifiable contact] or any other suitable alert means.

By state of health (or SOH) we include state of charge (or SOC). Where the term state of health indicator is used herein, it may also be a state of charge indicator, where the context allows and vice versa. By state of charge of an electrolyte, it is meant the level of charge of that electrolyte. The state of charge of a flow battery, as used herein, is preferably the state of charge of each (or both) of the electrolytes. In a preferred embodiment of a vanadium redox flow battery, by state of charge (SoC) of the positive electrolyte, it is meant the ratio of concentration of V(V) to total vanadium in the positive electrolyte, while the state of charge of the negative electrolyte is the ratio of concentration of V(II) to total vanadium in the negative electrolyte. In a perfectly balanced (and healthy) system the SoC of the positive and negative electrolytes will be equal.

State of health (SoH) may be defined in many different ways for different battery chemistries. Preferably, in the context of a vanadium redox flow battery system, by state of health it is meant how far the average oxidation state in the whole electrolyte of the system (both positive and negative electrolyte) has diverged from the original value (which, for a vanadium redox flow battery system, is ~ 3.50).

If the electrolyte has oxidised (e.g. through parasitic side reactions, such as hydrogen evolution; or oxygen ingress into the tanks) the average oxidation state will have increased. This will also be apparent as a difference in the SoC of the positive and negative electrolytes. In a situation in which the average oxidation state has reached at least 3.65, the vanadium flow battery may be considered to be in a "critical" state of health, where the positive half-cells could be accidentally over-charged, causing irreversible damage to the stacks. A rise in the average oxidation state also becomes apparent as a decrease in discharge energy.

In a preferred embodiment of the invention, the system will be determined to have a poor state of health if the average oxidation state deviates from the balanced or healthy state (i.e. typically, original state) by 0.10 (e.g. if it has an average oxidation state of 3.6 or more and may be considered to have a diminished state of health when the average oxidation state is 3.55 or more.

An average oxidation state can be determined from measurements of state of charge (e.g. of the positive electrolyte and across the reference cell) using the present system/arrangement on a single occasion, but is preferably calculated over an extended period, such as over a matter of hour or days or even a week or more, preferably relying on multiple measurements.

In one embodiment, the arrangement is configured to determine the state of charge of the positive electrolyte by determining the voltage difference between the positive half-cell of the reference cell and an auxiliary reference electrolyte arrangement as defined above linked via an ionic pathway conduit with the positive half-cell of the reference cell. The state of charge of the negative electrolyte may be determined either by determining the voltage difference between the negative half-cell of the reference cell and a second auxiliary reference cell as defined above linked via an ionic pathway conduit with the negative half-cell of the reference cell or (or additionally) by determining the difference between the measured the open-circuit voltage across the reference cell and the determined state of charge of the positive electrolyte (determined using the auxiliary reference electrolyte arrangement described above), preferably compensating for temperature variations. The state of charge of the negative electrolyte may, rather, be estimated as the 'average' state of charge, being a value obtained from the reference cell, which would generally be understood to lie between the state of charge of the positive and negative electrolytes.

When carrying out these measurements, the positive electrode gives a potential that is dependent on the state of charge of the positive electrolyte. The negative electrode gives a potential that is dependent on the state of charge of the negative electrolyte. The reference cell measures the difference between the positive and negative electrode potentials. Therefore, if one assumes that both electrolytes are well balanced, it gives a value for "whole battery state of charge" that is actually between that of the positive and negative state of charge values. This follows a rather complex relationship and is not simply the mean value.

In this preferred embodiment, the auxiliary reference electrode (after temperature compensation) provides a fixed voltage to compare to the positive electrode. This allows the positive electrolyte state of charge to be determined. This value can then be compared to the "whole battery state of charge" value (determined by measuring the voltage across the reference cell). If they are close, then the negative and positive state of charge values must be similar and the battery is considered "healthy". If the values are different, then there is a difference between the positive and negative electrolyte state of charge values, and the battery is "unhealthy".

The state of charge may be determined by the arrangement of the present invention by measuring the potential difference between a respective electrolyte and the auxiliary electrolyte arrangement as described above and then measuring and/or determining a proxy for the state of charge of the other electrolyte (e.g. by measure a potential difference across the electrolytes of the flo battery or more preferably of a reference cell). The state of charge of each electrolyte (or proxy for the state of charge) may then be determined by any suitable method, such as by pre-determined look-up tables for the particular system or by using a suitable empirical formula.

According to a preferred embodiment, the arrangement or system comprises a sensor for determining potential difference across the reference cell (which may be denoted as E_{ref} [V]), a sensor for determining the potential difference between the reference cell positive half-cell and the auxiliary reference cell (or pseudo reference cell) (which may be denoted as E_{ref-aux} [V]), a sensor for determining the reference cell temperature (denoted T₁ [°C]) and a sensor for determining the temperature of the auxiliary reference cell (denoted T₂ [°C]). The reference-cell state of charge, α, and positive electrolytethe charge, αₚₒₛ, may then be determined from a suitable look-up table or by way of applying an empirical formula.

In one embodiment, αis determined by iterating an empirical equation, e.g. of the form shown in Equation 1 below, which is appropriate for electrolyte containing 1.6 M total vanadium and 4.0 M total sulphate, until it converges. This equation has a similar form to the Nernst equation, which cannot be directly implemented, because the activities of the electroactive species are not known. ${E}_{ref} = 1.38 - 0.00193 . {T}_{1} + \frac{R \left({T}_{1}+273\right)}{F} ln \left(\frac{\left(1.8α+3\right) \left(1.8α+4.8\right) {α}^{2}}{{\left(1-α\right)}^{2}}\right)$ Where:F = 96500 C mol⁻¹
R = 8.314 J K⁻¹ mol⁻¹

The positive electrolyte state of charge, αₚₒₛ, may be determined by iterating an empirical equation, e.g. of the form shown in Equation 2 below (where both the reference and active electrolytes contain 1.6M total vanadium and 4.0 M total sulphate): $\begin{matrix}Δ {E}_{ref - pseudo} = - 0.1028 + 0.00060 \left({T}_{2}-25\right) - 0.00094 . \left({T}_{1}-25\right) \\ + \frac{1.15 R \left({T}_{1}+273\right)}{F} ln \left(\frac{{α}_{pos} {\left(1.8{α}_{pos}+4.8\right)}^{2}}{\left(1-{α}_{pos}\right)}\right)\end{matrix}$

In a preferred embodiment, where the measurements are taken at approximately 50% charge, but the measurement may be taken at any suitable level of charge, but are preferably taken relatively consistently at that level of charge. The mid-charge portion of the flow battery's charge status (e.g. from 20% to 80% charged, more preferably from 25% to 75% charged, still more preferably from 30% to 70% charged and more preferably still from 40% to 60% charge, and even 45% to 55%) is preferred, not least because the flow battery is more frequently in that portion than in other portions and because the measures and determinations made in that portion are associated with smaller errors.

By comparing the values of α and αₚₒₛ, e.g. as determined from the above empirical equations (or otherwise by a look-up table or similar), a determination as to the balance of the state of charge of the positive and negative electrolytes can be made. Thus,
if αₚₒₛ > α, the electrolyte is oxidized and rebalance is required
if αₚₒₛ = α, the electrolyte is balanced - rebalance is not required
if αₚₒₛ < α, the electrolyte is reduced - rebalance is not required

In a preferred embodiment, the values of α and αₚₒₛ may be integrated over an extended period of time (or an extended number of charge-discharge cycles). For example, the values of the values of α and αₚₒₛ may be integrated over a period of up to 30 days, more preferably over a period of 1 to 10 days. This is a useful period, because the system under general operating conditions oxidises rather slowly (typically the average oxidation state may change about 0.001 - 0.02 per month).

Preferably, measurements (of potential difference across the reference cell and between reference cell and auxiliary reference cell and also, preferably, of temperature) are taken during a discharge or charge cycle or action while electrolyte is in flow (and is flowing through the reference cell).

Furthermore, for cells using membranes which cause considerable concentration variances in the electroactive materials, it is preferred that any decisive measurement is made immediately following a full remixing of electrolytes. For membranes that do not cause significant changes in electroactive species, concentrations measurements may be made at any time.

In a further aspect of the invention, there is a method for maintaining a balanced state of charge or state of health, such as a balanced oxidation state in a redox flow battery, the method comprising monitoring the state of charge in the flow battery by providing a state of charge or state of heath indicator as described above and causing the state of charge indicator or state of health indicator (or controller configured in association therewith) to make periodic or action or event-dependent measurements of charge across the reference cell and between the auxiliary reference electrolyte and a respective half-cell of the reference cell and determining therefrom a state of charge and/or state of health of the system; and in dependence of the state of charge or oxidation state variance between the positive electrolyte and the negative electrolyte exceeding one or more pre-determined thresholds or meeting one or more predetermined criteria, causing one or more maintenance actions to be applied to the flow battery.

In one embodiment, the method comprises monitoring the state of charge in the flow battery by providing a state of charge indicator or state of health indicator such as that described above and causing the state of charge or state of health indicator to make periodic or action or event-dependent measurements of charge across the reference cell and between the auxiliary reference electrolyte and a respective half-cell of the reference cell and determining therefrom a state of charge of the system; and in dependence of the determined state of charge variance between the positive electrolyte and the negative electrolyte exceeding one or more pre-determined thresholds or meeting one or more pre-determined criteria, causing one or more maintenance actions to be applied to the flow battery.

In the event of a state of health of the flow battery which is diminished, at least, e.g. reaches a critical state (such as defined above), the system may optionally be configured to introduced performance limitations on the flow battery, such as to limit the maximum state of charge of the battery (e.g. as determined from the reference cell - which gives a value that lies between those of the positive and negative electrolytes). This reduces the risk of damage to the system, but also reduces the discharge energy of the battery.

In one embodiment, the method and system (e.g. the control system thereof) are configured to cause (or recommend) a remedial action. Preferably the system is configured to automate the remedial action in dependence on a determination of state of health that the oxidation state is greater than a predetermined value (e.g. greater than 0.05 than the original level). The remedial action may be selected from the addition of reducing agents into the electrolyte tanks (e.g. automated dosing of reducing agents into the electrolyte tank in dependence on a pre-determined state of charge variance) to convert some of the V(V) to V(IV) [for example, as described in WO-A-2018047079] and using an electrochemical rebalance cell to produce oxygen for introduction into the positive electrolyte tank to electrochemically reduce the average oxidation state of the vanadium in the electrolyte [such as described in JP-A-3315508].

The rebalance action (e.g. rate of adding reducing agent or rebalance cell current) may, for example, be proportional to the difference between average oxidation state and the target oxidation state, or it could have an on-off action, if it diverges by more than a pre-set amount.

In each case, any measured or determined state of charge values are preferably corrected for temperature in order to generate the state of charge or state of health data.

The invention will now be described in more detail, without limitation, with reference to the accompanying Figures.

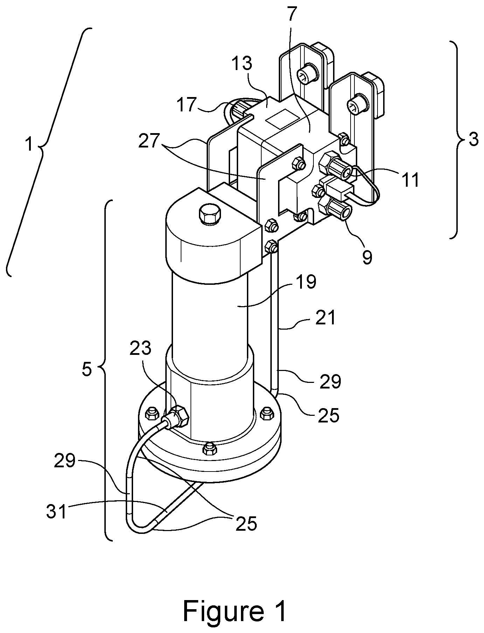

In Figure 1, a state of charge or state of health indicator arrangement 1 is illustrated, which has a reference cell 3 and associated therewith a single auxiliary reference electrolyte arrangement 5. The arrangement 1 is configured for use with a vanadium redox flow battery. Reference cell 3 comprises a negative half cell 7 and a positive half cell 13, each of which comprises a respective electrolyte reservoir (not shown). The negative half cell 7 is configured via a negative electrolyte inlet 9 and outlet 11 for negative electrolyte circulation with the negative electrolyte tank (not shown) or circuit of a flow battery (not shown) to which it may be connected. The positive half cell 13 is configured via positive electrolyte inlet (not shown) and outlet 17 for electrolyte circulation with the positive electrolyte tank (not shown) or circuit of a flow battery (not shown) to which it may be connected.

As in a standard reference cell, the potential difference may be measured across the reference cell 3, between the positive and negative half cells 7,13. This gives a snapshot of the measured state of charge of the flow battery because the positive and negative half cells 7,13 are in fluid circulation with the positive and negative electrolyte tanks of the flow battery.

The auxiliary reference electrolyte arrangement 5 has a cylindrical auxiliary electrolyte reservoir 19 for housing a reference electrolyte, which may be the original composition of the positive electrolyte of the flow battery or a comparative electrolyte composition, at a pre-defined state of charge, typically close to 50% state of charge. The reference electrolyte in the auxiliary electrolyte reservoir 19 is in ionic connection with the positive electrolyte reservoir of the positive half cell 13 of the reference cell 3 by way of a tube 21 providing an ionic pathway conduit between the auxiliary electrolyte reservoir 19 and positive half cell 13 via tube connecter 23 at a lower portion of the auxiliary electrolyte reservoir 19 and a reference cell linkage (not shown) in a base of the positive half cell 13.

The conduit pathway tube 21 provides an open, continuous fluid link between the auxiliary electrolyte reservoir 19 and the electrolyte in the positive half cell 13, without any blockages or obstructions such as membranes or valves. The conduit pathway tube 21 provides an uninterrupted ionic connection between the auxiliary electrolyte reservoir 19 and the positive half cell 13 of the reference cell 3, which allows an accurate voltage difference measurement to be made between the reference electrolyte in the auxiliary electrolyte reservoir 19 and the positive electrolyte of the flow battery in the positive half cell 13.

The tube 21 has a length of 60 cm (but can be up to 1.5 m) and an internal bore diameter of 3.2 mm. This length and diameter, while providing an ionic link between the reference electrolyte in the auxiliary electrolyte reservoir 19 and the positive electrolyte in the positive half cell 13, is sufficiently inhibitory to mixing the reference electrolyte (of 500 ml volume, but may preferably be lower, e.g. 100 ml) with the positive electrolyte in the positive half cell 13 to essentially maintain the composition of the reference electrolyte over an extended period of time and to enable continuous reliable and consistent reference measurements.

To further inhibit fluid mixing between the reference electrolyte and the positive electrolyte in the positive half cell 13, the tube 21 is provided with a number of bends 25, each curving about a 90° change in angle of the tube. Together the tube in two vertical portions 29 and horizontal portion 31 and separating bends 25 form a U-bend. The resulting U-bend arrangement, with the lowest point (horizontal portion 31) lower than both the auxiliary electrolyte reservoir 19 and the positive electrode 13.

The absence of obstruction or interruption in the tube 21 between the auxiliary reference reservoir 19 and the positive half cell 13 helps maintain a low resistivity, ideally < 1 MOhm, through the tube 21 so that the voltage difference between the reference electrolyte and the positive electrolyte of the flow battery in the positive half cell 13 may be accurately measured and with little interference from electronic "noise".

In use, the auxiliary electrolyte reservoir 19 should be charged with sufficient reference electrolyte to substantially fill the reservoir 19 and tube 21 and should be essentially gas free.

The auxiliary reservoir arrangement 5 is physically mounted to the reference cell 3 by way of brackets 27 mounted in relation to an upper portion of the auxiliary electrolyte reservoir 19 and against a front or side surface of the reference cell 3. The auxiliary electrolyte reservoir 19 is thus disposed at a lower position than the reference cell in use, further reducing the risk of reference electrolyte mixing and flowing back and fore into the positive cell half 13.

Reference cell electrodes (not shown) are disposed in each of the positive and negative half cells 7,13 of the reference cell 3 and in relation thereto a means to measure a potential difference across the half cell (not shown) is provided along with means to store and/or communicate the resulting data. An auxiliary electrode (not shown) is disposed in the auxiliary electrolyte reservoir 19 and a means to measure

Each of the positive half cell 13 and the auxiliary electrolyte reservoir 19 is provided with a thermal sensor (not shown) to measure the respective electrolyte temperatures.

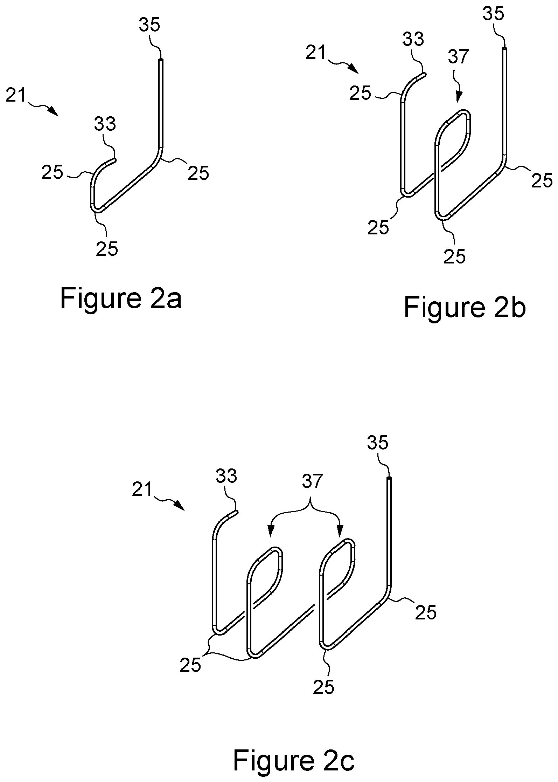

In Figures 2a, 2b and 2c are illustrated three versions of an ionic pathway conduit or tube 21 for use in a state of charge indicator arrangement 1. The tube 21 in Figure 2a is that used in the auxiliary reservoir arrangement 1 of Figure 1. According to Figure 2a, tube 21 has an auxiliary reservoir end 33 for connecting to the auxiliary electrolyte reservoir 19 (Figure 1) via ionic pathway tube connector 23 and a reference cell end for connecting to a positive half cell 13 (or either half-cell), the two ends 33,35 separated by a length of tube 21 of about 60 cm. The tube in Figure 2a has an internal bore diameter of 3.2 mm and is characterised by a number of bends 25 along its length, preferably to form a U-bend.

The tubing material may be any suitable material that is stable to the electrolyte. This may typically include one or a blend of a number of polymers, such as polyethylene, polypropylene, polyvinyl chloride, polytetrafluoroethylene and polyvinylidene fluoride as well as, optionally, a flexible polymer (e.g. Tygon^{®} tubing). Preferably, tube is translucent or transparent (so as to observe any gas locks or particulate blockages).

Prferably the tubing is provided with a wicking means (as described above) extending through the tubing (which wicking means is not shown).

Figures 2b and 2c illustrate variant tubes 21 that may be used in place of the tube 21 in Figure 2a in any particular system. The tubes in Figures 2b and 2c differ in that they are provided with further bends 25 so as to form one or more loops 37. The loops 37 as shown are formed by a series of straight tube portions interspersed with 90°bend portions, although the loops 37 can take any geometric shape, such as oval or circular/spiralled. The provision of one loop 37 as in Figure 2b reduces the diffusion and thus interchange of electrolyte (and in particular vanadium) between the auxiliary electrolyte reservoir 19 and the reference cell 3, thereby extending the period for which a stable reading from the auxiliary electrolyte reservoir can be achieved. The provision of a second loop 37 as in Figure 2c significantly reduces the diffusion of electrolyte between the auxiliary electrolyte reservoir 19 and reference cell 3 relative to the U-bend shape of Figure 2a and the single loop version of Figure 2b. Thus, by providing one or more loops 37 (or further U-bends) in the tube 21 for use in an arrangement 1 of Figure 1, the tube 21 may serve to extend the period before which electrolyte from the reference cell 3 mixes to an unacceptable extent with the electrolyte in the auxiliary electrolyte reservoir 19 or may be adapted by shortening the tube 21 or increasing its internal bore diameter in order to achieve the same performance (in terms of diffusion inhibition) as that in Figure 2a.

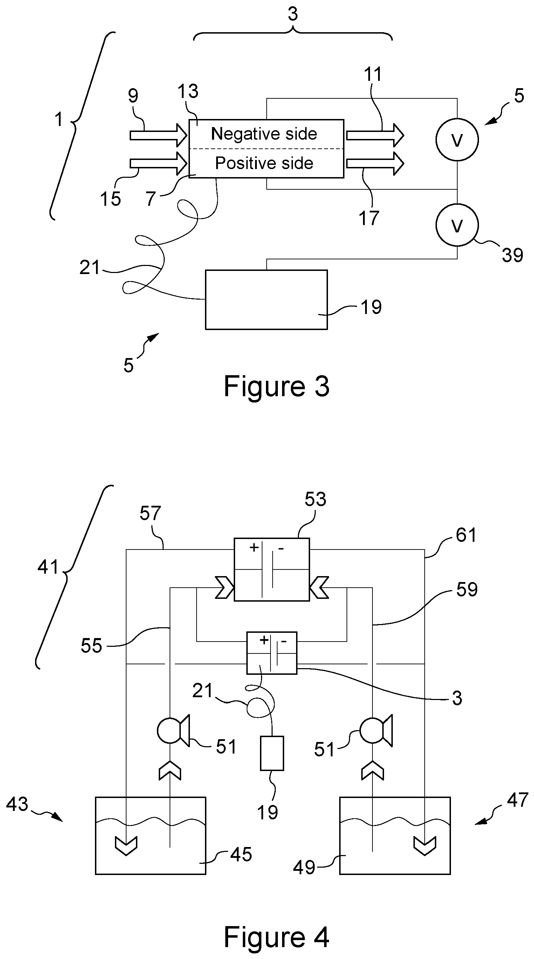

In Figure 3, a schematic of a state of charge indicator arrangement 1 according to an embodiment of the invention comprises a reference cell 3 having a positive side 7, negative side 13 and a voltmeter 5 disposed across the cell for measuring potential difference. The indicator arrangement further comprises the auxiliary reference electrolyte arrangement 5 comprising reservoir 19 and narrow bore tube 21 (as an ionic conduit path) linked to the positive side 7 of reference cell 3. The positive and negative sides 7,13 have respective inlets 15,9 of positive and negative electrolyte into the reference cell 3 from the pipes feeding positive and negative electrolyte respectively from the electrolyte tanks of the fuel cell into the cell stack (ideally just before the cell stack) and outlets 17,11 to return positive and negative electrolyte from the reference cell 3 to pipes returning from the cell stack to the electrolyte tanks (or directly to the electrolyte tanks).

Potential difference across the reference cell 3 may be measured by voltmeter 5, while potential difference between the positive side 7 of reference cell 3 and auxiliary reservoir 19 may be measured via voltmeter 39.

In Figure 4, the position of a of a state of charge indicator arrangement is shown in the context of a vanadium redox flow battery 41 which comprises a positive electrolyte tank 43 containing a positive electrolyte 45 and a negative electrolyte tank 47 containing a negative electrolyte 49. The positive and negative electrolytes 45, 49 are circulated by pumps 51 through cell stack 53 by positive feed line 55 and positive return 57 and negative feedline 59 and return line 61. Disposed parallel to the cell stack 53 is reference cell 3 which is fed by positive and negative inlets 15,9 from positive and negative feed lines 55 and 59 and returned via positive and negative outlets 17,11 to positive and negative returns 57 and 61. The positive side 7 of reference cell 3 is linked to auxiliary electrolyte reservoir 19 by curved narrow bore pipe 21.

When the pumps 51 are operating, electrolyte may circulate through the cell stack 53 and through reference cell 5. Potential difference measurements are best taken when the pumps are operating.

When the state of charge of the positive electrolyte 45 is measured to have a different state of charge to that of the negative electrolyte 47 (as estimated by measuring the potential difference across the reference cell 5), the flow battery 41 may be configured to allow remedial actions such as dosing of reducing agent into the electrolyte.

### EXAMPLES

### Example 1

A state of charge or state of health indicator was set up in relation to a vanadium oxide redox flow battery, in accordance with the arrangement shown in Figure 1 in which a reference cell was connected in parallel to a stack in a redox flow battery (for a 5 kW stack in a 40 kWh battery).. The auxiliary reference electrolyte was positive electrolyte at 50% SOC.

The battery initially contained discharged electrolyte at close to 0% state of charge. The battery was charged, with the pumps running continuously.

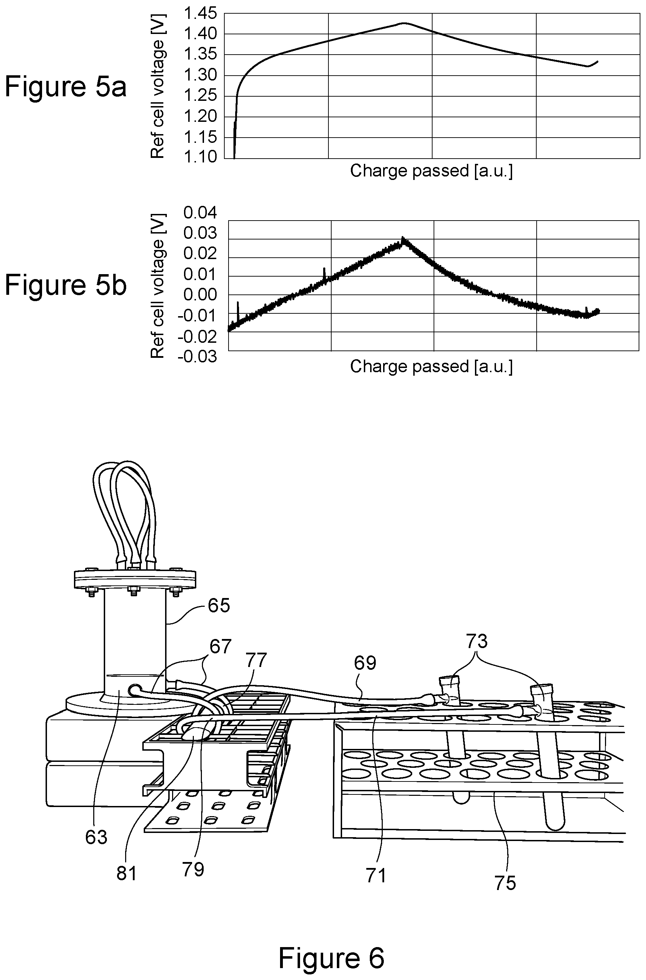

Figures 5a and 5b are plots of potential difference across the reference cell (Figure 5a) and potential difference between the positive electrode of the reference cell and the auxiliary electrolyte of the auxiliary reference arrangement (Figure 5b), in each case plotted against absolute charge passed through the stack.

As can be seen in Figure 5a, the continuous charging (as expected) caused the reference cell voltage to increase and then, while the battery was discharged, a decrease in reference cell voltage is observed (followed by a very small final charging period, when the reference cell voltage increased again). The measurable voltage range across the reference cell was 0 to 1.6V, with an active range from 1.25 V to 1.45 V.

The potential difference was also measured by the voltmeter between the between the positive electrode of the reference cell and the auxiliary electrode (of the auxiliary reference arrangement) and is shown in Figure 5b. This measure had a low value when the positive electrolyte had a state of charge lower than the auxiliary electrolyte (which was at 50% state of charge) and a higher value when it was above the charge level of the auxiliary electrolyte. To obtain the exact difference temperature compensation is required for the reference cell and auxiliary reservoir. (Assuming they are isothermal, the positive electrolyte would be at 50% state of charge when the potential difference was zero). The active voltage range between the positive electrode of the reference cell and the auxiliary electrolyte of the auxiliary reference arrangement was -0.01 to 0.04 V.

The measures of potential difference at any particular point in the charging/discharging of the battery (or averaged across a part of a charge cycle, a charge cycle or multiple charge cycles) may be inserted into the empirical equations above (or used against look-up tables) to determined values for f αₚₒₛ and α, so as to assess the state of health of the flow battery.

### Example 2

A series of diffusion tests were carried out to compare conduit dimensions and geometries in the context of diffusion/mixing of fluids for use in the auxiliary reference electrolyte arrangement of the present invention.

In this experiment, tanks of electrolyte were connected to test tubes of sulphuric acid (acting as the reference cell and pseudo-reference cell, respectively) and the progress of electrolyte through the tubing monitored. The tanks and test tubes were connected using different lengths of tubing of different geometries to understand the relationship each of these factors had on the diffusion of the electrolyte. As sulphuric acid is colourless, the concentration of electrolyte (blue) in the test tubes could be measured using UV-vis. Comparing the concentration of electrolyte with the elapsed time, the rate of diffusion could be quantified.

Six comparative experiments were set up using a 4.8 mm internal diameter Tygon^{®} tubing, with the following lengths and geometries:

| | |
|---|---|
| A | 30 cm length; double loop |
| B | 30 cm length; straight (no loop) |
| C | 30 cm length; single loop |
| D | 50 cm length; straight (no loop) |
| E | 50 cm length; single loop |
| F | 50 cm length; double loop |

The experiments were set-up as follows with the arrangement shown in Figure 6 (which shows the experiment with tubes E and F above).

Two sealed side-arm test-tubes 73 were disposed in a test tube rack 75. The side-arm test tubes 73 were connected to the outlets 67 via 50 cm lengths of 4.8 mm internal diameter Tygon^{®} tubing 69,71, extending largely horizontally. One length of tubing 71 (experiment E above) was provided with one vertically orientated loop 79 by looping the tube about a rod (cork) 81 having a diameter of about 150-200 mm diameter. The second length of tubing 69 (experiment F above) was provided with two vertically orientated loops 77 by looping the tube twice about rod 81.

Prior to connecting to the outlets 67, the test tubes 73 were filled with 4.2 M sulfuric acid until the test tubes 73 and the connected tubes 69,71 were filled (15.2 ml), then the ends of the tubes clamped, close to their free ends. The test tubes 73 were then sealed with caps. The tubes 69,71 were then connected to an electrolyte storage vessel 65 via two outlets 67 disposed close to the bottom of the vessel at a level similar to that of the side-arms of the test tubes 73.

A quantity of 1.6 M TMS² vanadium electrolyte 63 was provided into the electrolyte storage vessel 65 to a level about the level of the two outlets 67. The clamps were then removed.

In order to test the diffusion, 1 ml samples were taken (at irregular intervals starting about 2 months from the start of the experiment) from the test tubes and replaced with 1 ml sulfuric acid. The extracted samples were measured by UV/vis against a sulfuric acid standard (4.2 M).

The average rate of vanadium permeation was calculated from the UV/vis data measured and is presented in Table 1 below as the diffusion rate in mol/day:

**Table 1**

| | A | B | C | D | E | F |
|---|---|---|---|---|---|---|
| mol/day | <1 x 10⁻⁶ | n/a | 1.04 x 10⁻⁵ | 6.24 x 10⁻⁵ | 7.79 x 10⁻⁶ | 1.30 x 10⁻⁶ |

| | | | | | | |
|---|---|---|---|---|---|---|
| *Note: no result is recorded for sample B which was fully mixed at the end of the experiment* | | | | | | |

It was determined from the above experiment, that with the criteria that the state of charge in an auxiliary reservoir be within 2% of the initial value after 12 months, and having two loops in the tubing, the auxiliary reservoir could be <100 ml in volume. This would give an advantage in terms of cost and integration of an auxiliary reservoir into the system while remaining effective.

This was calculated with the following approach/assumptions
- the auxiliary electrolyte reference arrangement state of charge initially = 0.50, and total vanadium concentration, [V] = 1.8 mol dm⁻³
- The concentration of V(IV) in the auxiliary electrolyte reference arrangement = [V(IV)]
- There is a constant movement of V(IV) into the reference cell, at D_{V} (and no V(V) diffuses into the reference cell - this is clearly a "worst case" approximation)
- There is an equal rate of displacement of vanadium (at the state of charge in the auxiliary electrolyte reference arrangement)
- The auxiliary electrolyte reference arrangement volume = V

The V(IV) concentration in the auxiliary electrolyte reference arrangement, [V(IV)] is given by: $\frac{d \left[V\left(IV\right)\right]}{dt} = \frac{{D}_{V} . SOC}{V}$ $\frac{d \left[V\left(IV\right)\right]}{dt} = - \left[V\right] . \frac{dSOC}{dt}$ $\frac{dSOC}{dt} = - \frac{{D}_{V} . SOC}{V . \left[V\right]}$ $SOC = a . {e}^{- \frac{{D}_{V} . t}{V . \left[V\right]}}$ $As {SOC}_{t = 0} = 0.50 , \left[V\right] = 1.8$ $SOC = 0.50 {e}^{- \frac{{D}_{V} . t}{1.8 V}}$

Taking a maximum acceptable deviation from the starting SOC as 0.02, and the minimum time to this deviation as 1 year $V = \frac{- 365 {D}_{V}}{1.8 ln \left(\frac{0.48}{0.50}\right)} = 4970 {D}_{V}$ where D_{V} is expressed in mol.d⁻¹ and V in L.

For the tube connections above, the auxiliary electrolyte reference arrangement volumes shown in Table 2 below would meet the indicated criteria.

**Table 2**

| | A | B | C | D | E | F |
|---|---|---|---|---|---|---|
| D_{V} [mol d⁻¹] V [ml] | <1 x 10⁻⁶ <5 | n/a - | 1.04 x 10⁻⁵ 51.7 | 6.24 x 10⁻⁵ 310 | 7.79 x 10⁻⁶ 38.7 | 1.30 x 10⁻⁶ 6.5 |

### Example 3

A test was carried out to investigate the ability of a 3 mm amorphous silica wick to maintain ionic connectivity through an ionic pathway tube (having an inner diameter of 3.18 mm) when the tube comprises trapped gas bubbles.

A tube material that is known to react with electrolyte and create a gas was selected so that gas bubbles were created during the test. A 3 mm amorphous silica wick was inserted along the full length of the tube. The tube was disposed between and in fluid communication with two electrolyte reservoirs. The reservoirs and tubes were filled with electrolyte. During the test a large gas bubble formed along almost the entire length of the tube.

The test was continued to monitor the performance of the silica wick under these conditions. The resistance between carbon fibre rods disposed in the electrolyte reservoirs increased over time as a large bubble formed - from ~ 1.6 kΩ to a peak of ~ 40 kΩ at 21 days. It is presumed that the peak occurred at the maximum extent of bubble formation. As the test continued the resistance decreased steadily to ~ 15 kΩ at 43 days and remained steady up to the time of reporting (i.e. at 70 days). Over the test period the wick changed colour from dark blue to light green and appeared to be stable with no signs of degradation.

As can be seen, despite the total occlusion of the tube by the large bubble, the resistance between the carbon fibre rods in the respective reservoirs remained at a relatively low level and stabilised over time. Thus, the test of Example 3 demonstrates that even when large bubbles are fully occluding a tube acting as an ionic pathway conduit between two electrolyte reservoirs, a wicking means disposed within the tube can nevertheless maintain ionic conductivity through the length of the tube and between the electrolyte reservoirs.

The invention has been described with reference to a preferred embodiment. However, it will be appreciated that variations and modifications can be effected by a person of ordinary skill in the art without departing from the scope of the invention as defined in the appended claims.

## Claims

1. A state of charge indicator arrangement (1) for a redox flow battery system (41) comprising a redox flow battery cell stack (53), a positive electrolyte tank (43) and pipework to circulate positive electrolyte (45) through the cell stack (53) and a negative electrolyte tank (47) and pipework to circulate negative electrolyte (49) through the flow battery cell stack (53), the indicator arrangement (1) comprising:
a reference cell (3) arrangement comprising a means for measuring potential difference between a positive electrolyte (45) of or from the positive electrolyte tank (43) of a flow battery (41) and a negative electrolyte (49) of or from the negative electrolyte tank (47) of a flow battery (41); and
at least one auxiliary reference electrolyte arrangement (5) comprising
a discrete auxiliary electrolyte reservoir (19) for housing a redox electrode in association with a reference electrolyte of known composition comparable to the desired or initial composition of the flow battery electrolyte (45, 49) for which it provides a reference and having known state of charge;
a means (39) of measuring the potential difference between the or each auxiliary reference electrolyte and the respective electrolyte (45, 49) of the reference cell (3) arrangement; and
an ionic pathway conduit (21) linking the or each auxiliary reference electrolyte reservoir with the respective electrolyte of the reference cell (3) arrangement, which conduit (21) is configured for low fluid diffusion capability or rate, wherein the conduit (21) comprises a wicking means for absorbing electrolyte and maintaining ionic connection between the auxiliary reference electrolyte reservoir and the respective electrolyte (45, 49) of the reference cell (3) arrangement.

2. A state of charge indicator (1) as claimed in claim 1, wherein the wicking means extends continuously along a full length of the ionic pathway conduit (21); and/or wherein the wicking means extends from the ionic pathway conduit (21) into the auxiliary reference electrolyte reservoir and/or the respective electrolyte (45, 49) of the reference cell arrangement.

3. A state of charge indicator (1) as claimed in any one of the preceding claims, wherein the wicking means is hydrophilic and/or electrically non-conducting.

4. A state of charge indicator (1) as claimed in any one of the preceding claims,
wherein the wicking means comprises silica, ceramic and/or hydrophilic polymer; and/or
wherein the wicking means is a wick or cord.

5. A state of charge indicator (1) as claimed in any one of the preceding claims, wherein the ionic pathway conduit (21) comprises a tubular member providing a fluid connection between the auxiliary reference electrolyte reservoir and the respective electrolyte (45, 49) of the reference cell (3) arrangement.

6. A state of charge indicator (1) as claimed in claim 5, wherein the wicking means is disposed inside the tubular member (21).

7. A state of charge indicator (1) as claimed in any one of the preceding claims, wherein the ionic pathway conduit (21) is absent any membranes or barrier and is openly fluidly connected between the auxiliary reference electrolyte and the respective electrolyte (45, 49) of the reference cell (3) arrangement.

8. A state of charge indicator (1) as claimed in any one of the preceding claims, wherein the ionic pathway conduit (21) has an inner diameter of from 0.5 mm to 10 mm.

9. A state of charge indicator (1) as claimed in any one of the preceding claims, wherein the wicking means is a wick or cord having a diameter smaller than an inner diameter of the ionic pathway conduit (21).

10. A state of charge indicator (1) as claimed in any one of the preceding claims, wherein the redox flow battery (41) is a vanadium redox flow battery (41).

11. A state of health indicator system for a redox flow battery system (41), the indicator system comprising a state of charge indicator arrangement (1) as defined in any one of claims 1 to 10 and configured to determine a state of health of the redox flow battery system (41) therefrom.

12. An auxiliary reference electrolyte (5) arrangement for a state of charge indicator (1) as defined in any one of claims 1 to 10, the auxiliary reference electrolyte arrangement (5) comprising
a discrete auxiliary electrolyte reservoir (19) for housing a redox electrode in association with a reference electrolyte of known composition comparable to the desired or initial composition of the flow battery electrolyte (45, 49) for which it provides a reference and having known state of charge;
a means (39) of measuring the potential difference between the or each auxiliary reference electrolyte and an associated electrolyte of a reference cell arrangement or an associated half-cell of a reference cell; and
an ionic pathway conduit (21) for linking the or each auxiliary reference electrolyte reservoir with an electrolyte (45, 49) in a respective electrolyte of a reference cell (3) arrangement or a respective half-cell of a reference cell (3), which conduit (21) is configured for low fluid diffusion capability or rate, wherein the conduit (21) comprises a wicking means for absorbing electrolyte and maintaining ionic connection between the auxiliary reference electrolyte reservoir and the respective electrolyte (45, 49) of the reference cell (3) arrangement or a respective half-cell of a reference cell (3).

13. A redox flow battery (41) comprising a redox flow battery cell stack (53), a positive electrolyte tank (43) and pipework to circulate positive electrolyte (45) through the cell stack (53) and a negative electrolyte tank (47) and pipework to circulate negative electrolyte (49) through the flow battery cell stack (53) and a state of charge indicator (1) as defined in any one of claims 1 to 10.

14. A method of monitoring the state of charge and/or state of health in a redox flow battery (41), the method comprising providing a state of charge indicator (1) as claimed in any one of claims 1 to 10 and causing the state of charge indicator to make periodic measurements of charge across the reference cell (3) and between the auxiliary reference electrolyte and a respective half-cell of the reference cell (3) and determining therefrom a state of charge of the system.

15. A method for maintaining a balanced state of charge or oxidation state in a redox flow battery (41), the method comprising:
monitoring the state of charge in the flow battery (41) by providing a state of charge indicator (1) as claimed in any one of claims 1 to 10 and causing the state of charge indicator (1) to make periodic or action or event-dependent measurements of charge across the reference cell (3) and between the auxiliary reference electrolyte and a respective half-cell of the reference cell (3) and determining therefrom a state of charge and/or state of health of the system; and
in dependence of the state of charge or oxidation state variance between the positive electrolyte (45) and the negative electrolyte (49) exceeding one or more pre-determined thresholds or meeting one or more pre-determined criteria, causing one or more maintenance actions to be applied to the flow battery (41).

## Patentansprüche

1. Ladezustandsanzeigeanordnung (1) für ein Redox-Flow-Batteriesystem (41), umfassend einen Redox-Flow-Batteriezellenstapel (53), einen Tank (43) für positiven Elektrolyt und eine Verrohrung zum Zirkulieren von positivem Elektrolyt (45) durch den Zellenstapel (53) und einen Tank (47) für negativen Elektrolyt und eine Verrohrung zum Zirkulieren von negativem Elektrolyt (49) durch den Flow-Batteriezellenstapel (53), wobei die Anzeigeanordnung (1) umfasst:
eine Anordnung einer Referenzzelle (3), umfassend ein Mittel zum Messen einer Potenzialdifferenz zwischen einem positiven Elektrolyt (45) oder von dem Tank (43) für positiven Elektrolyt einer Flow-Batterie (41) und
einem negativen Elektrolyt (49) oder von dem Tank (47) für negativen Elektrolyt einer Flow-Batterie (41); und mindestens eine Zusatzreferenzelektrolytanordnung (5), umfassend:
ein separates Zusatzelektrolytreservoir (19) zum Beherbergen einer Redox-Elektrode in Assoziation mit einem Referenzelektrolyt mit bekannter Zusammensetzung, die mit der gewünschten oder Anfangszusammensetzung des Flow-Batterie-Elektrolyts (45, 49) vergleichbar ist, für den sie eine Referenz bereitstellt und einen bekannten Ladezustand aufweist;
ein Mittel (39) zum Messen der Potenzialdifferenz zwischen dem oder jedem Zusatzreferenzelektrolyt und dem jeweiligen Elektrolyt (45, 49) der Anordnung der Referenzzelle (3); und
eine Ionenwegleitung (21), die das oder jedes Zusatzreferenzelektrolytreservoir mit dem jeweiligen Elektrolyt der Anordnung der Referenzzelle (3) verknüpft, wobei diese Leitung (21) für ein niedriges Fluiddiffusionsvermögen oder eine niedrige Fluiddiffusionsrate konfiguriert ist, wobei die Leitung (21) ein Dochtwirkungsmittel zum Absorbieren von Elektrolyt und Aufrechterhalten einer ionischen Verbindung zwischen dem Zusatzreferenzelektrolytreservoir und dem jeweiligen Elektrolyt (45, 49) der Anordnung der Referenzzelle (3) umfasst.

2. Ladezustandsanzeige (1) nach Anspruch 1, wobei sich das Dochtwirkungsmittel kontinuierlich entlang einer vollen Länge der Ionenwegleitung (21) erstreckt; und/oder wobei sich das Dochtwirkungsmittel von der Ionenwegleitung (21) in das Zusatzreferenzelektrolytreservoir und/oder den jeweiligen Elektrolyt (45, 49) der Anordnung der Referenzzelle erstreckt.

3. Ladezustandsanzeige (1) nach einem der vorhergehenden Ansprüche, wobei das Dochtwirkungsmittel hydrophil und/oder elektrisch nichtleitend ist.

4. Ladezustandsanzeige (1) nach einem der vorhergehenden Ansprüche,
wobei das Dochtwirkungsmittel Siliziumdioxid, Keramik und/oder hydrophiles Polymer umfasst; und/oder wobei das Dochtwirkungsmittel ein Docht oder eine Kordel ist.

5. Ladezustandsanzeige (1) nach einem der vorhergehenden Ansprüche, wobei die Ionenwegleitung (21) ein rohrförmiges Element umfasst, das eine Fluidverbindung zwischen dem Zusatzreferenzelektrolytreservoir und dem jeweiligen Elektrolyt (45, 49) der Anordnung der Referenzzelle (3) bereitstellt.

6. Ladezustandsanzeige (1) nach Anspruch 5, wobei das Dochtwirkungsmittel im Inneren des rohrförmigen Elements (21) angeordnet ist.

7. Ladezustandsanzeige (1) nach einem der vorhergehenden Ansprüche, wobei der Ionenwegleitung (21) jegliche Membranen oder Barriere fehlen und sie zwischen dem Zusatzreferenzelektrolytreservoir und dem jeweiligen Elektrolyt (45, 49) der Anordnung der Referenzzelle (3) offen fluidverbunden ist.

8. Ladezustandsanzeige (1) nach einem der vorhergehenden Ansprüche, wobei die Ionenwegleitung (21) einen Innendurchmesser von 0,5 mm bis 10 mm aufweist.

9. Ladezustandsanzeige (1) nach einem der vorhergehenden Ansprüche, wobei das Dochtwirkungsmittel ein Docht oder eine Kordel mit einem Durchmesser ist, der kleiner als ein Innendurchmesser der Ionenwegleitung (21) ist.

10. Ladezustandsanzeige (1) nach einem der vorhergehenden Ansprüche, wobei die Redox-Flow-Batterie (41) eine Vanadium-Redox-Flow-Batterie (41) ist.

11. Gesundheitszustandsanzeigesystem für ein Redox-Flow-Batteriesystem (41), wobei das Anzeigesystem eine Ladezustandsanzeigeanordnung (1) nach einem der Ansprüche 1 bis 10 umfasst und dazu konfiguriert ist, einen Gesundheitszustand des Redox-Flow-Batteriesystems (41) davon zu bestimmen.

12. Anordnung eines Zusatzreferenzelektrolyts (5) für eine Ladezustandsanzeige (1) nach einem der Ansprüche 1 bis 10, wobei die Zusatzreferenzelektrolytanordnung (5) umfasst:
ein separates Zusatzelektrolytreservoir (19) zum Beherbergen einer Redox-Elektrode in Assoziation mit einem Referenzelektrolyt mit bekannter Zusammensetzung,
die mit der gewünschten oder Anfangszusammensetzung des Flow-Batterie-Elektrolyts (45, 49) vergleichbar ist,
für den sie eine Referenz bereitstellt und einen bekannten Ladezustand aufweist;
ein Mittel (39) zum Messen der Potenzialdifferenz zwischen dem oder jedem Zusatzreferenzelektrolyt und
einem assoziierten Elektrolyt einer Anordnung einer Referenzzelle oder einer assoziierten Halbzelle einer Referenzzelle; und
eine Ionenwegleitung (21) zum Verknüpfen des oder jedes Zusatzreferenzelektrolytreservoirs mit einem Elektrolyt (45, 49) in einem jeweiligen Elektrolyt einer Anordnung einer Referenzzelle (3) oder einer jeweiligen Halbzelle einer Referenzzelle (3), wobei diese Leitung (21) für ein niedriges Fluiddiffusionsvermögen oder eine niedrige Fluiddiffusionsrate konfiguriert ist, wobei die Leitung (21) ein Dochtwirkungsmittel zum Absorbieren von Elektrolyt und Aufrechterhalten einer ionischen Verbindung zwischen dem
Zusatzreferenzelektrolytreservoir und dem jeweiligen Elektrolyt (45, 49) der Anordnung der Referenzzelle (3) oder einer jeweiligen Halbzelle einer Referenzzelle (3) umfasst.

13. Redox-Flow-Batterie (41), umfassend einen Redox-Flow-Batteriezellenstapel (53), einen Tank (43) für positiven Elektrolyt und eine Verrohrung zum Zirkulieren von positivem Elektrolyt (45) durch den Zellenstapel (53) und einen Tank (47) für negativen Elektrolyt und eine Verrohrung zum Zirkulieren von negativem Elektrolyt (49) durch den Flow-Batteriezellenstapel (53) und eine Ladezustandsanzeige (1) nach einem der Ansprüche 1 bis 10.

14. Verfahren zur Überwachung des Ladezustands und/oder des Gesundheitszustands in einer Redox-Flow-Batterie (41), wobei das Verfahren ein Bereitstellen einer Ladezustandsanzeige (1) nach einem der Ansprüche 1 bis 10 und ein Bewirken, dass die Ladezustandsanzeige periodische Messungen einer Ladung über die Referenzzelle (3) und zwischen dem Zusatzreferenzelektrolyt und einer jeweiligen Halbzelle der Referenzzelle (3) vornimmt, und ein Bestimmen eines Ladezustands des Systems daraus umfasst.

15. Verfahren zur Aufrechterhaltung eines ausgeglichenen Ladezustands oder Oxidationszustands in einer Redox-Flow-Batterie (41), wobei das Verfahren umfasst:
Überwachen des Ladezustands in der Flow-Batterie (41) durch Bereitstellen einer Ladezustandsanzeige (1) nach einem der Ansprüche 1 bis 10 und Bewirken, dass die Ladezustandsanzeige (1) periodische oder aktions- oder ereignisabhängige Messungen einer Ladung über die Referenzzelle (3) und zwischen dem Zusatzreferenzelektrolyt und einer jeweiligen Halbzelle der Referenzzelle (3) vornimmt, und Bestimmen eines Ladezustands und/oder eines Gesundheitszustands des Systems daraus; und
in Abhängigkeit davon, dass die Ladezustands- oder Oxidationszustandsvarianz zwischen dem positiven Elektrolyt (45) und dem negativen Elektrolyt (49) einen oder mehrere vorbestimmte Schwellenwerte übersteigt oder ein oder mehrere vorbestimmte Kriterien erfüllt, Bewirken, dass eine oder mehrere Wartungsaktionen auf die Flow-Batterie (41) ausgeübt werden.

## Revendications

1. Agencement d'indicateur d'état de charge (1) pour un système de batterie à flux redox (41) comprenant un empilement de cellules de batterie à flux redox (53), un réservoir d'électrolyte positif (43) et une tuyauterie pour faire circuler un électrolyte positif (45) à travers l'empilement de cellules (53) et un réservoir d'électrolyte négatif (47) et une tuyauterie pour faire circuler un électrolyte négatif (49) à travers l'empilement de cellules de batterie à flux (53), l'agencement d'indicateur (1) comprenant :
un agencement de cellule de référence (3) comprenant un moyen de mesure d'une différence de potentiel entre un électrolyte positif (45) du ou provenant du réservoir d'électrolyte positif (43) d'une batterie à flux (41) et un électrolyte négatif (49) du ou provenant du réservoir d'électrolyte négatif (47) d'une batterie à flux (41) ; et
au moins un agencement d'électrolyte de référence auxiliaire (5) comprenant
un réservoir d'électrolyte auxiliaire discret (19) pour recevoir une électrode redox en association avec un électrolyte de référence de composition connue comparable à la composition souhaitée ou initiale de l'électrolyte de batterie à flux (45, 49) pour lequel il fournit une référence et présentant un état de charge connu ;
un moyen (39) de mesure de la différence de potentiel entre le ou chaque électrolyte de référence auxiliaire et l'électrolyte (45, 49) respectif de l'agencement de cellule de référence (3) ; et
un conduit de trajet ionique (21) reliant le ou chaque réservoir d'électrolyte de référence auxiliaire à l'électrolyte respectif de l'agencement de cellule de référence (3), lequel conduit (21) est configuré pour une capacité ou un taux de diffusion de fluide faible, dans lequel le conduit (21) comprend un moyen à effet de mèche pour absorber l'électrolyte et maintenir une liaison ionique entre le réservoir d'électrolyte de référence auxiliaire et l'électrolyte (45, 49) respectif de l'agencement de cellule de référence (3).

2. Indicateur d'état de charge (1) selon la revendication 1, dans lequel le moyen à effet de mèche s'étend en continu sur toute la longueur du conduit de trajet ionique (21) ; et/ou dans lequel le moyen à effet de mèche s'étend à partir du conduit de trajet ionique (21) dans le réservoir d'électrolyte de référence auxiliaire et/ou l'électrolyte (45, 49) respectif de l'agencement de cellule de référence.

3. Indicateur d'état de charge (1) selon l'une quelconque des revendications précédentes, dans lequel le moyen à effet de mèche est hydrophile et/ou électriquement non-conducteur.

4. Indicateur d'état de charge (1) selon l'une quelconque des revendications précédentes,
dans lequel le moyen à effet de mèche comprend une silice, une céramique et/ou un polymère hydrophile ; et/ou
dans lequel le moyen à effet de mèche est une mèche ou un cordon.

5. Indicateur d'état de charge (1) selon l'une quelconque des revendications précédentes, dans lequel le conduit de trajet ionique (21) comprend un élément tubulaire assurant une liaison fluidique entre le réservoir d'électrolyte de référence auxiliaire et l'électrolyte (45, 49) respectif de l'agencement de cellule de référence (3).

6. Indicateur d'état de charge (1) selon la revendication 5, dans lequel le moyen à effet de mèche est disposé à l'intérieur de l'élément tubulaire (21).

7. Indicateur d'état de charge (1) selon l'une quelconque des revendications précédentes, dans lequel le conduit de trajet ionique (21) est dépourvu de toute membrane ou barrière et est en communication fluidique ouverte entre l'électrolyte de référence auxiliaire et l'électrolyte (45, 49) respectif de l'agencement de cellule de référence (3).

8. Indicateur d'état de charge (1) selon l'une quelconque des revendications précédentes, dans lequel le conduit de trajet ionique (21) présente un diamètre interne de 0,5 mm à 10 mm.

9. Indicateur d'état de charge (1) selon l'une quelconque des revendications précédentes, dans lequel le moyen à effet de mèche est une mèche ou un cordon présentant un diamètre plus petit qu'un diamètre interne du conduit de trajet ionique (21).

10. Indicateur d'état de charge (1) selon l'une quelconque des revendications précédentes, dans lequel la batterie à flux redox (41) est une batterie à flux redox (41) au vanadium.

11. Système indicateur d'état de santé pour un système de batterie à flux redox (41), le système indicateur comprenant un agencement d'indicateur d'état de charge (1) tel que défini dans l'une quelconque des revendications 1 à 10 et configuré pour déterminer un état de santé du système de batterie à flux redox (41) à partir de celui-ci.

12. Agencement d'électrolyte de référence auxiliaire (5) pour un indicateur d'état de charge (1) comme défini dans l'une quelconque des revendications 1 à 10, l'agencement d'électrolyte de référence auxiliaire (5) comprenant
un réservoir d'électrolyte auxiliaire discret (19) pour recevoir une électrode redox en association avec un électrolyte de référence de composition connue comparable à la composition souhaitée ou initiale de l'électrolyte de batterie à flux (45, 49) pour lequel il fournit une référence et présentant un état de charge connu ;
un moyen (39) de mesure de la différence de potentiel entre le ou chaque électrolyte de référence auxiliaire et un électrolyte associé d'un agencement de cellule de référence ou une demi-cellule associée d'une cellule de référence ; et
un conduit de trajet ionique (21) pour relier le ou chaque réservoir d'électrolyte de référence auxiliaire à un électrolyte (45, 49) dans un électrolyte respectif d'un agencement de cellule de référence (3) ou une demi-cellule respective d'une cellule de référence (3), lequel conduit (21) est configuré pour une capacité ou un taux de diffusion de fluide faible, dans lequel le conduit (21) comprend un moyen à effet de mèche pour absorber l'électrolyte et maintenir une liaison ionique entre le réservoir d'électrolyte de référence auxiliaire et l'électrolyte (45, 49) respectif de l'agencement de cellule de référence (3) ou une demi-cellule respective d'une cellule de référence (3).

13. Batterie à flux redox (41) comprenant un empilement de cellules de batterie à flux redox (53), un réservoir d'électrolyte positif (43) et une tuyauterie pour faire circuler un électrolyte positif (45) à travers l'empilement de cellules (53) et un réservoir d'électrolyte négatif (47) et une tuyauterie pour faire circuler un électrolyte négatif (49) à travers l'empilement de cellules de batterie à flux (53) et un indicateur d'état de charge (1) tel que défini dans l'une quelconque des revendications 1 à 10.

14. Procédé de surveillance de l'état de charge et/ou de l'état de santé dans une batterie à flux redox (41), le procédé comprenant la fourniture d'un indicateur d'état de charge (1) selon l'une quelconque des revendications 1 à 10 et la commande de l'indicateur d'état de charge pour effectuer des mesures périodiques de charge à travers la cellule de référence (3) et entre l'électrolyte de référence auxiliaire et une demi-cellule respective de la cellule de référence (3) et la détermination d'un état de charge du système à partir de celles-ci.

15. Procédé de maintien d'un état de charge équilibré ou d'un état d'oxydation équilibré dans une batterie à flux redox (41), le procédé comprenant :
la surveillance de l'état de charge dans la batterie à flux (41) en fournissant un indicateur d'état de charge (1) selon l'une quelconque des revendications 1 à 10 et en amenant l'indicateur d'état de charge (1) à effectuer des mesures de charge périodiques ou dépendantes d'une action ou d'un événement à travers la cellule de référence (3) et entre l'électrolyte de référence auxiliaire et une demi-cellule respective de la cellule de référence (3) et la détermination d'un état de charge et/ou d'un état de santé du système à partir de celles-ci ; et
en fonction de la variance de l'état de charge ou de d'état d'oxydation entre l'électrolyte positif (45) et l'électrolyte négatif (49) dépassant un ou plusieurs seuil(s) prédéterminé(s) ou satisfaisant un ou plusieurs critère(s) prédéterminé(s), la commande de l'application d'une ou plusieurs action(s) de maintenance à la batterie à flux (41).
